# EUROPEAN PATENT APPLICATION

(11) **EP 1 754 807 A2**
(43) Date of publication of application: **21.02.2007**
(21) Application number: 06254348.3
(22) Date of filing: 18.08.2006
(51) Int. Cl.: C30B 11/00, F27B 14/08, F27D 1/00

(54) **An insulation package for use in high temperature furnaces**

(30) Priority: 18.08.2005 US 709715 P
(71) Applicant: BP Corporation North America Inc., Warrenville, IL 60555 (US)
(72) Inventor: Clark, Roger F., Frederick, Maryland 21701 (US); Cliber, James A., Emmitsburg, Maryland 21727 (US); Stark, Douglas L., Mount Airy, Maryland 21771 (US); Heck, Daniel P., Walkersville, Maryland 21793 (US)
(74) Representative: Hamer, Christopher K.

(57) **Abstract**

A high-temperature furnace for melting materials, e.g. silicon, wherein the furnace comprises a vessel having a wall which defines an inner chamber. A crucible containing the material to be melted is positioned inside of the chamber and heating means is arranged around the crucible. An insulation package is provided in the chamber for protecting the vessel wall from the heat generated by said heating means. Specifically, the package comprises a support ring of insulation mounted in the chamber, a sleeve of insulation supported on the ring and extending upward between the heating means and the vessel wall, a catch tray adapted to receive any material which may leak from the crucible during heating mounted through the support ring, and a top and a lower layer of insulation to thermally seal the crucible within the package during heating.

## Description

This application claims the benefit of U.S. Provisional Patent Application 60/709,715 filed on August 18, 2005.

### FIELD OF THE INVENTION

The present invention relates to a package or jacket for insulating between internal heating elements and the wall of a high temperature furnace and a method of installing the insulation package within the furnace.

### BACKGROUND OF THE INVENTION

In recent years, considerable advances have been made in photovoltaic (PV) cells or the like for directly converting solar energy into useful electrical energy. A typical PV cell is comprised of wafers or films of silicon which, in turn, are assembled into laminates or panels by various processes well known in the solar module art. The laminates or panels can then be installed onto the appropriate support structure (e.g. the roof of a house, building, or the like) or can be used directly as a building material, (e.g. "building integrated") to provide electrical energy.

Typically, the silicon wafers for PV cells are produced by melting and fusing pieces of silicon into a solid mass which then is cooled and crystallized before cutting into wafers of the required thickness. A well known system for melting silicon pieces into the desired mass is one in which a ceramic crucible, filled with the silicon pieces is placed into the chamber of a furnace. Electrical heating elements are positioned within the chamber so that they surround the crucible and lie between the crucible and the inner wall of the furnace.

Since the crucible has to be heated to temperatures (e.g. about 1500° C) which can cause serious damage to the wall of the furnace if left unchecked, (a) the furnace wall is water-cooled and (b) the gap between the heating elements and the furnace wall is filled with insulation so that the intense heat generated by the heating elements does not bear directly on the furnace wall. This insulation also prevents the cooling from the water cooled furnace wall from affecting or lowering the heat conveyed to the crucible from the heating elements.

In the known prior furnaces of this type, the insulation package is comprised of several large and many small individual pieces (e.g. 30 pieces or more) of insulation and support structure (e.g. layers of carbon or graphite) which have to be independently installed and fitted into the spaces between the heating elements and the furnace wall. This is both labor intensive and time consuming in that the individual pieces must be properly fitted together by the installers while they work within the furnace. Accordingly, this operation adds to the overall costs involved in the melting operation. Further, the interior surface of the insulation is prone to reaction when exposed to the melting atmosphere within the furnace and degrades over time that sometimes requires early replacement of the insulation package. As can be appreciated, this amounts to another expense which has to be considered in the production of PV cells.

Still further and of major importance, if and when the crucible fractures during heating (not uncommon), liquid silicon comes into contact with portions of the insulation, especially that below the bottom of the crucible. This leaking liquid silicon can, and usually does, damage the insulation package to the point that the affected portions of the insulation package can not be reused. This also can add significantly to the costs of the operation since the type of insulation required is very expensive. Accordingly, having to replace a substantial portion of the insulation package whenever there is a spill, the overall costs are further increased. Since solar technology is extremely competitive with other, more conventional energy sources, keeping the costs of manufacture as low as possible is a very important consideration in the successful marketing of solar power to the public.

### SUMMARY OF THE INVENTION

The present invention provides an insulation package for protecting the wall of a furnace used in melting materials, e.g. silicon, from the high temperature required for melting the material and a method for installing the insulation package into the furnace. The insulation package of the present invention is comprised of a relatively few pieces of insulation when considering the large number of individual, pieces required in known prior art furnaces. Further, the time needed to install the package is substantially reduced as are the fitting requirements of the installers. Further, the present insulation package includes a catch tray positioned below the crucible in the furnace so that if the crucible fractures or cracks during the melting operation, any leaking silicon will be caught in the tray without affecting other parts of the insulation package.

More specifically, the present invention provides a furnace in which the present insulation package can be utilized. The high-temperature furnace is comprised of a vessel having a wall which defines a inner chamber. A crucible is positioned in the chamber and is filled with the material (e.g. silicon) to be melted. A heating means (e.g. a plurality of electrical heating elements) which is capable of generating the necessary heat is positioned in the chamber and surrounds the crucible.

The insulation package of the present invention is positioned in the chamber so as to protect the wall of the vessel from the intense heat generated by the heating means. More specifically, the insulation package is comprised of a support ring that is mounted in the chamber below the crucible and has a central opening therethrough. A sleeve of insulation material is supported on the support ring and extends upward to effectively fill the gap between the wall of the vessel and the heating means.

A catch tray also having a central opening therethrough is positioned within the central opening through the support ring and is supported on the ring. The catch tray is positioned so that it will catch any liquid material which may leak from the crucible during heating. The present insulation package further includes a top layer of insulation which extends over the top of the sleeve and a lower layer of insulation which effectively seals the opening through the catch ring during heating to thermally isolate the crucible within the insulation package. The support ring, sleeve, catch tray, upper layer, and lower layer are all comprised of any suitable insulation material which is capable of withstanding the high temperatures generated by the heating means and of sufficient strength to be self supporting, e.g. available insulation material comprised of carbon or graphite materials formed as rigidized felt, bonded fiber, or soft felt interspersed with structural carbon or carbon-fiber pieces.

### BRIEF DESCRIPTION OF THE DRAWINGS

The actual construction operation, and apparent advantages of the present invention will be better understood by referring to the drawings, not necessarily to scale, in which like numerals identify like parts and in which:

FIG. 1 is a cross-section view of the furnace of present invention when in heat-up position without the outer water jacket;

FIG. 2 is a cross-section view of the furnace of FIG. 1, when in the growth position;

FIG. 3 is a sectional view taken along line 3-3 of FIG. 2; and

FIG. 4 is an enlarged perspective view, partly in section, of the insulation package or jacket of the present invention.

While the invention will be described in connection with its preferred embodiments, it will be understood that this invention is not limited thereto. On the contrary, the invention is intended to cover all alternatives, modifications, and equivalents that may be included within the spirit and scope of the invention, as defined by the appended claims.

### DETAILED DESCRIPTION OF THE INVENTION

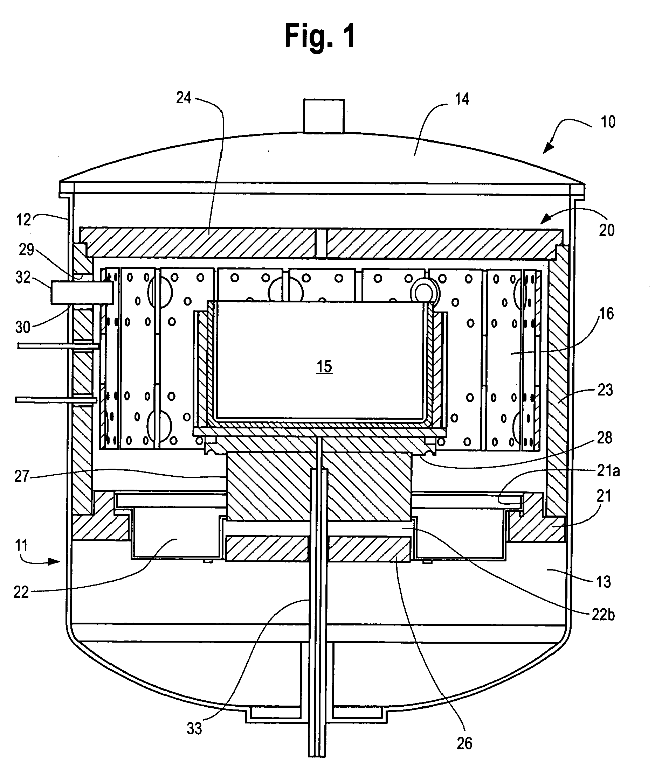

Referring now to drawings, FIG. 1 illustrates the furnace 10 of the present invention when the furnace is in its "heat-up position". The outer configuration and outer features of furnace 10 are basically the same as those of known, prior art furnaces of this type. That is, furnace 10 is comprised of a vessel 11 having a cylindrical wall 12 which forms an inner chamber 13. Wall 12 and top closure or cap 14 are formed of any suitable material, e.g. stainless steel, that is capable of withstanding the temperature involved in the heating operation. The dimensions of a typical furnace 10 are relatively large in order to accommodate the large, square crucible 15 (e.g. 69cm x 69cm x 42cm high) which are typically used in silicon melting operations of this type. One example of such a known furnace is GT-MX225 HEM Furnace, distributed by GT Equipment Technologies, Merrimack, NH.

In prior known furnaces of this type, heating means similar to the present heating means (e.g. electrical heating elements 16 in FIG. 1) are positioned within chamber 12 so that they will encircle crucible 15 when the crucible is in place and provide the heat for melting the material in crucible 15, e.g. silicon. However, the temperatures needed to melt materials such as silicon are so high (e.g. about 1500° C) that the heat will damage the wall 12 of the vessel 11 if the wall is left unprotected. In addition to water-cooling the wall 12 of the vessel 11 (not shown), large amounts of insulation have to be provided between the heating elements 16 and the wall 12 of the vessel to further protect the wall from the excessive heat.

In the known prior-art furnaces of this type, providing sufficient insulation requires hand wrapping the heating elements 16 (i.e. furnace liner) with carbon felt and securing the felt with graphite string before the elements are positioned in the chamber. Holes are cut through the felt wrapping to receive the electrodes which are necessary to supply power to the heating elements. Also additional insulation, (e.g. sets of graphite hearth plates, trimmed to fit, not shown) is required within the chamber vessel to protect vital areas of the chamber from severe heat damage.

Providing the insulation necessary for such prior furnaces is both labor intensive and time consuming, hence expensive. For example, in one known furnace used for melting large volumes of silicon, the insulation package consists of twenty (20) lower support pieces, twenty-eight (28) lower insulation pieces, eight (8) center insulation pieces, a liner system that is hand-wrapped with loose insulation, nine (9) upper edge pieces, and a 15-piece upper insulation assembly; making a total of eighty-two (82) separate pieces. These pieces have to be installed individually and then fitted together once inside the chamber to form the required insulation package. It can readily be seen that this amounts to a substantial part of the overall cost of such an operation.

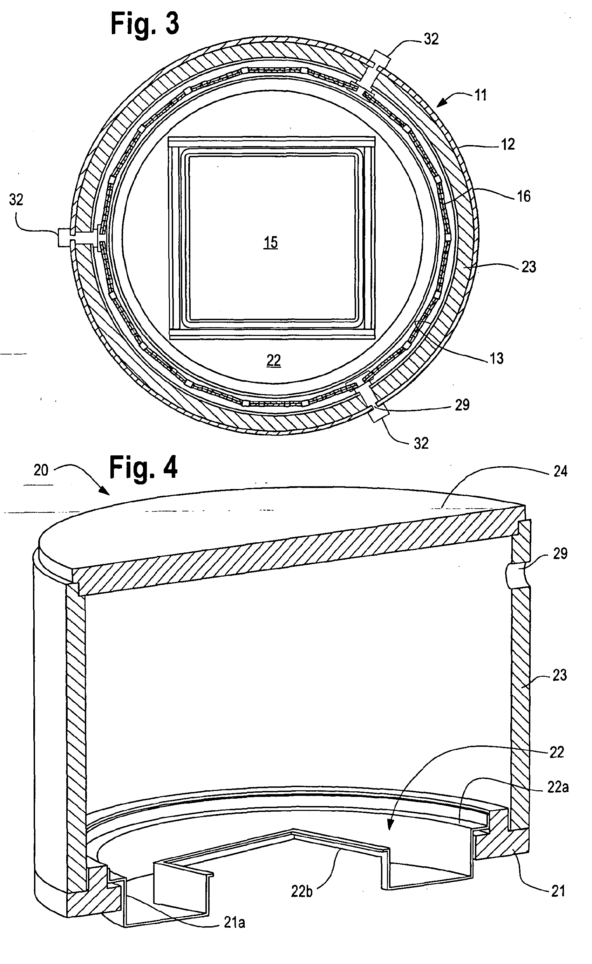

In accordance with the present invention, a insulation package or jacket 20 (used interchangeably throughout), see FIG. 4, is provided which substantially replaces the individual pieces of the prior furnace's insulation package; i.e. reduces the required pieces from about eighty (80) pieces to about twelve (12)). By doing so, the time required in installing the required insulation is substantially reduced, making the melting of large volumes of silicon both less expensive and, by reducing the cost of manufacturing solar cells, the overall costs of producing solar cells and electrical energy from solar cells are reduced.

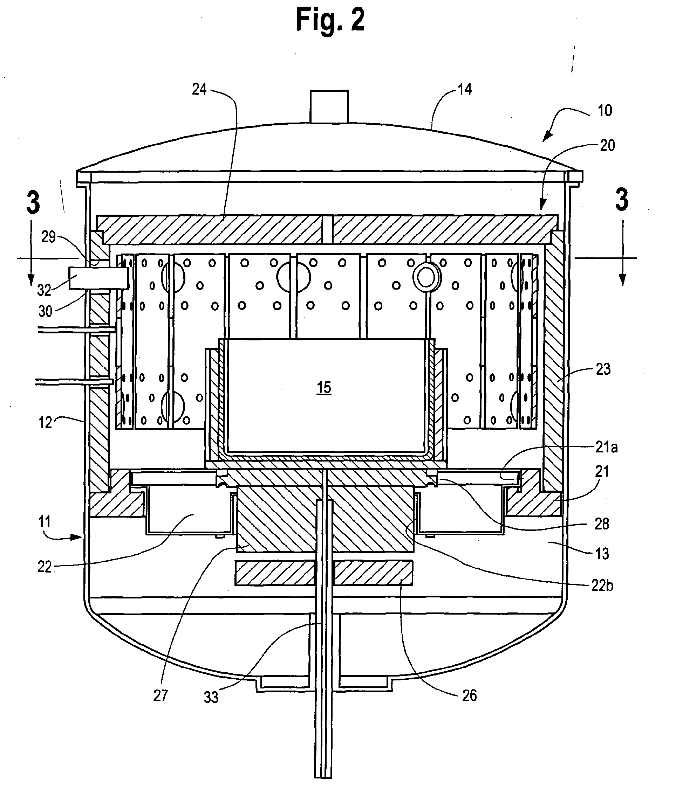

Basically, insulation jacket 20 is comprised of insulation base ring 21 having a central opening 21a, catch tray 22 having a central opening 22b, insulation sleeve or cylinder 23, top insulation layer or cover 24, and a lower insulation layer 26. The furnace also includes a crucible support means, i.e. support block 27 and support plate 28, both being comprised of high temperature conductive material (e.g. graphite)(see FIGS. 1 and 2). The insulation used in the support ring 21, catch tray 22, sleeve 23, and top 24 and lower layers 26 in the present package 20 may be of any suitable material which is capable of withstanding the extreme temperatures involved and of sufficient strength to be self-supporting; e.g. carbon and/or graphite insulation such as that fabricated by Carbon Composites, Inc., Leominster, MA. Also, while the various components, e.g. cylindrical sleeve 23, top 24, bottom insulation layer 26, etc., are illustrated as being of a single thickness or integral composition, it should be understood that each of these components can also be formed from multi-sheets or stacked layers of insulation to build-up the desired thickness without departing from the present invention.

In installing package 20 into vessel 11, base ring 21 is installed onto its support (not shown for clarity) within the lower part of the vessel with the cylindrical sleeve 23 positioned on the ring 21 and extending upward between heating elements 16 and the wall 12 of vessel 11, as shown in the FIGS.. As should be understood, sleeve 23 can be positioned onto the ring 21 and installed therewith or it may be positioned on the ring after the ring has been placed in the vessel. Holes 29 are then drilled or otherwise formed through insulation cylindrical sleeve 23 in alignment with openings 30 in the wall 12 of vessel 11 for a purpose explained below. Next, catch tray 22 is inserted through opening 21a in ring 21 so that a shoulder 22a on the tray 22 rests on and is supported by ring 21 (see FIG. 4).

Next the heating means, e.g. heating elements 16, is installed within cylinder 23 and held in place by electrodes 32 inserted through aligned openings 29, 30 in the wall 12 of vessel and sleeve 23 and electrically connected to elements 16 to thereby provide the power for heating the furnace. Once this is done, the bottom insulation pack 26 is installed.

Catch tray 22 has a central opening 22b therethrough which is approximately the same size and configuration as that of lower insulation layer 26 and support block 27. As can be seen from comparing FIGS. 1 and 2, this allows both layer 26 and block 27 to move into and out of central opening 22b for a purpose described below. Lower insulation layer 26 is connected to movement arms (not shown) separate from support block 27. Support block 27 is affixed to shaft 33 so that it will move in unison with the shaft as will be further explained below. Support plate 28 which is larger than opening 22b in tray 22 and slightly smaller or approximately the same size as crucible 15 is then positioned onto block 27 from within tray 22.

Crucible 15 is then positioned onto support plate 27 and is filled with the material to be melted (e.g. silicon). Top insulation cover 24 is installed and secured onto the top of sleeve 23 to effectively thermally isolate the crucible and heating elements 16 within the insulation package 20. Vessel 11 is then closed by securing a cover 14 or the like in place and power is supplied to heating elements 16 through electrodes 32 to begin the heat-up operation; see FIG. 1. That is, shaft 33 is raised to position crucible 15 in the approximate center, both radially and longitudinally, of heating elements 16 to maximize the heat within the furnace. In this position, both support block 27 and more importantly, lower insulation layer 26 lie within opening 22b of catch tray 22. Lower insulation layer 26 effectively acts as a "valve" to block the escape of heat from the heating elements during the heating operation, thereby maximizing the heat being transmitted to crucible 15 and protecting vessel 11.

Once the material in crucible 15 is melted, furnace 10 is moved to its "growth" or cooling position (FIG. 2). That is, shaft 33 is moved downward to move the crucible 15 and block 27 downward to the position shown in FIG. 2. More importantly, lower insulation layer 26 is moved below and out of opening 22b in tray 22. This now allows heat to flow or dissipate through the graphite block 27 (graphite being a good heat conductor) and out into the chamber 13 of vessel 11.

If crucible 15 should fracture during the heating or cooling operation (not uncommon under the extreme conditions involved), any leaking material (e.g. silicon) will be caught in the catch tray 22. If a leak should happen, only the tray 22 is affected and only the tray will need to be discarded. The rest of the insulation package or jacket 20 can be reused thereby resulting in substantial savings since replacement of insulation is expensive.

U.S. Provisional Patent Application 60/709,715 filed on August 18, 2005, is incorporated herein by reference in its entirety.

## Claims

1. A high-temperature furnace for melting materials in a crucible positioned within said furnace, said furnace comprising:
a vessel having a wall which defines an inner chamber;
heating means within said chamber, said heating means adapted to generate and supply the necessary heat to said crucible to melt said material; and
an insulation package for protecting said wall of said vessel from said heat generated by said heating means, said insulation package comprising:
a support ring mounted in said chamber in a location below a crucible positioned within said chamber, said support ring having a central opening therethrough;
a sleeve of insulation material supported on said support ring and extending upward between said heating means and said wall of said vessel;
a catch tray having a central opening mounted in said opening of said support ring, said catch tray having a central opening and being adapted to receive any material which may leak from said crucible during heating; and
a top layer of insulation which extends over the top of said sleeve to thermally isolate said crucible within said insulation package.

2. The furnace of claim 1 wherein said support ring, said sleeve, said catch tray, and said top layer are comprised of an insulation material capable of withstanding the maximum temperature generated by said heating means.

3. The furnace of claim 2 wherein said insulation is comprised of carbon and/or graphite formed as rigidized felt, bonded fiber, or soft felt interspersed with structural carbon or carbon-fiber pieces.

4. The furnace of claim 2 including:
a shaft movably mounted in said vessel, said shaft being movable between a heat-up and a growth position;
a support means affixed to the upper end of said shaft and adapted to support said crucible thereon; and
a lower insulation layer affixed to said shaft and adapted (a) to lie within said central opening in said catch tray when said shaft is in said heat-up position to block the flow of heat from said heating elements through said central opening in said catch tray and (b) to lie below and out of said central opening in said catch tray when said shaft is in said growth position to allow the flow of heat through said central opening in said catch tray.

5. The furnace of claim 4 wherein said support means comprises:
a support block affixed to said shaft and having a configuration substantially matching said opening in said catch tray whereby said block can move therein; and
and a support plate positioned on said support block and adapted to support a crucible.

6. The furnace of claim 5 wherein said support block and said support plate are comprised of graphite.

7. An insulation package for protecting the wall of a high temperature furnace from the internal heat generated during the melting of a material, said furnace being comprised of a vessel having a wall which defines an internal chamber, heating means within said chamber, and a crucible for holding the material to be melted; said insulation package comprising:
a support means adapted to be mounted in said chamber below said crucible;
a sleeve of insulation material adapted to be supported on said support means and extending upward between said wall of said vessel and said heating means when in an operable position;
a catch tray adapted to be mounted on said support means whereby said catch tray will receive any material which may leak from said crucible during melting; and
a top layer of insulation adapted to extend over the top of said sleeve to thermally isolate said crucible within said insulation package when said insulation package is assembled within said chamber.

8. The insulation package of claim 7 wherein said support means comprises:
a support ring having a central opening therethrough;
and wherein said catch tray has a central opening therethrough.

9. The insulation package of claim 8 including:
a lower layer of insulation adapted to block the flow of heat through said central opening in said catch tray during heating.

10. The insulation package of claim 9 wherein said support ring, said sleeve, said catch tray, said top layer and said lower insulation layer are comprised of an insulation material capable of withstanding maximum temperature generated by said heating means.

11. The furnace of claim 10 wherein said insulation is comprised of carbon and/or graphite formed as rigidized felt, bonded fiber, or soft felt interspersed with structural carbon or carbon-fiber pieces.

12. A method for installing an insulation package in a furnace to protect the wall of said furnace; said furnace comprising a vessel having said wall which defines a chamber which in turn has heating means therein; said method comprising:
positioning a support ring having a central opening within said vessel;
positioning a sleeve of insulation on said support ring whereby said sleeve extends upward between said heating means and said wall of said vessel; and
positioning a catch tray within said central opening in said support ring to catch any material which might leak during operation of said furnace.

13. The method of claim 12 including:
positioning a top layer of insulation across the top of said sleeve, and
positioning a lower layer of insulation in said central opening of said catch tray to thermally isolate said heating means from said wall of said vessel.

14. The method of claim 13 wherein said support ring, said sleeve, said catch tray, said top layer and said lower insulation layer are comprised of an insulation material capable of withstanding maximum temperature generated by said heating means.

15. The method of claim 14 wherein said insulation is comprised of carbon and/or graphite formed as rigidized felt, bonded fiber, or soft felt interspersed with structural carbon or carbon-fiber pieces.

16. A process comprising melting silicon in the furnace of claim 1 to form molten silicon.

17. The process of claim 16 further comprising cooling the molten silicon in said furnace.
